Europäisches Patentamt

European Patent Office

Office européen des brevets

(19)

(11) Publication number: **0 383 814 B1**

(12) **EUROPEAN PATENT SPECIFICATION**

(45) Date of publication of patent specification: **15.09.93**  (51) Int. Cl.5: **H03H 17/02**

(21) Application number: **88909593.1**

(22) Date of filing: **21.10.88**

(86) International application number:
**PCT/GB88/00918**

(87) International publication number:
**WO 89/04088 (05.05.89 89/10)**

(54) **IMPROVED FILTERING TECHNIOUES.**

(30) Priority: **21.10.87 GB 8724619**
**11.01.88 GB 8800509**
**02.09.88 GB 8821682**

(43) Date of publication of application:
**29.08.90 Bulletin 90/35**

(45) Publication of the grant of the patent:
**15.09.93 Bulletin 93/37**

(84) Designated Contracting States:
**AT BE CH DE FR GB IT LI LU NL SE**

(56) References cited:
**US-A- 0 075 681**
**US-A- 4 439 840**

**IEEE Transactions on Acoustics, Speech,
and Signal Processing, vol. ASSP-33, no. 3,
June 1985, IEEE (N.Y., US), Y.H. Lee et al.:
Generalized median filtering and related
nonlinear filtering techniques, pages 672-683**

(73) Proprietor: **BANGHAM, James Andrew**
**26 Park Lane**
**Norwich NR2 3EE(GB)**

(72) Inventor: **BANGHAM, James Andrew**
**26 Park Lane**
**Norwich NR2 3EE(GB)**

(74) Representative: **Nash, Keith Wilfrid et al**
**KEITH W. NASH & Co. Pearl Assurance
House 90-92 Regent Street
Cambridge CB2 1DP (GB)**

EP 0 383 814 B1

## Description

Field of invention.

This invention concerns the filtering of data to remove unwanted signals (e.g. noise) using one or more ordinal value filters.

Background to the invention

A real time ordinal value filter which determines which one of a set of R applied data values is the Nth -largest, becomes a median filter if R is odd and N is made equal to $(R+1)/2$. In such a mode the filter provides as an output the "middle" value of the data set, having in general an equal number of other data values from the set larger and smaller than itself.

The design and operation of median filters is described inter alia in U.S. Patents 4441165, 4439840, 4560974 and 45135440.

In a simple case of linear array of data samples, if $R=3$ and $N=2$, the median value is the middle value of each three successive data values when the latter are sorted into order, beginning with the smallest and ending with the largest of each group of three. Since there is no averaging the median filter will remove spurious samples without degrading sharp transitions in the original sample series. Put another way, if the data samples represent a regularly sampled, time dependent signal, then the median filter has the property of not restricting the band width of the signal (which would degrade steep transitions in the original signal) but instead allows original signal transitions, representing long duration features, to be transmitted at full band width while substantially attenuating shorter durations spurious spikes, characteristic of electrical noise.

The particular threshold at which such a filter will eliminate spurious signals but pass other signals is determined by the values of R and N. The greater the number of atypical samples that represent the spurious signal that is to be eliminated, the greater will have to be the value of R.

However it has been found that a median filter, set to eliminate spurious signals represented by less than N samples for example, may actually introduce spurious signals into the filter output, if transitions of the original signal (relating to the information) are closer together than N sampling intervals. Such spurious signals have the effect of increasing the number of samples representing the true signal event. This can have serious repercussions if the information is contained, at least in part, in the number of samples representing the amplitude excursions in the original.

In an attempt to further enhance noise reduction, it has been proposed to repeat a median filtering step by applying the filtered signal from a first median filter, either to the input of the same filter again or to a second identical filter. At first it was thought that this might overcome the introduction of spurious signals as discussed above, but it has been found that this repeated ordinal value filtering does not remove all spurious signals introduced by the first ordinal value filter.

Experiments have shown that the introduction of adventitious information into the filter output is reduced when the value of R is small. For example, in the case of a linear sequence of samples, if $R=3$, it would appear that there is little likelihood of any spurious additional signals appearing in the output. By appropriate choice of sampling interval, a median filter with a value of $R=3$ should not introduce any unwanted signal transitions in the filter output signal. However spurious signals represented by three or more samples will not be supressed, which when the sampling rate is high, may not result in very satisfactory noise reduction.

Increasing the number of samples representing a given signal will not necessarily result in an increase in the accuracy of the filtered signal since the value of R has to be increased to take account of the greater number of sampling intervals which will have occured during a given spurious noise signal spike.

The present invention seeks to overcome this apparently fundamental problem associated with ordinal value filters (and median filters in particular), when they are employed to remove unwanted signals, e.g. to clean up "noisy" electrical signals.

Summary of the invention

A method of ordinal value filtering to remove unwanted items of data from wanted items of data in a conglomerate of items, comprises the steps of
(i) selecting a group of the items from the conglomerate,
(ii) processing the selected items of data by successive ordinal value filtering with increasing order, to provide a first data output,
(iii) selecting at least one different group of the items from the conglomerate and processing each different group by the same succession of increasing order ordinal value filtering to provide second and subsequent data outputs, and
(iv) either applying the succession of data outputs as the filtered output or combining the succession of data outputs with other data, to form the filtered output signal.

Where the conglomerate of items of data is in one dimension (e.g. a series of electrical signals whose amplitude varies, and spaced by distance and/or time) the selected groups may comprise groups of successive ones of the varying amplitude signals.

Where the conglomerate of items of data is in two dimensions, (e.g. sampled values of an electrical signal arising from the scanning of a succession of lines in a television type scanner) the selected groups may comprise successive similar arrays of the sampled values, each group including sample values from two or more lines of the original scanning so that each group can be thought of as relating to a small area of the total scanned area.

The present invention therefore provides a method of ordinal value (for example median) filtering to remove spurious noise spikes ranging in duration, area or volume, from one signal sample up to a maximum of (M-1) samples, in which the filter comprises a series of ordinal value filters (typically median filters), of increasing order, and the number of samples included in the groups applied to the succession of filters together with the geometrical arrangement of the samples in each group is selected to produce the derived properties of the overall filter.

An overall filter can be referred to as a data-sieve.

A data-sieve is designed as follows:-

(1) Two masks are used to characterise any particular filter. A first mask S2 is used to identify all samples (items) to be included in the final filter of the series of filters.

(2) The position of one of the samples encompassed by the first mask S2 is then chosen as the origin of the first mask, and a second mask S1 (smaller than S2) is centered on the origin of S2 so as to encompass a subset of the samples within by S2.

(3) The samples to be included in the first ordinal value filter (order 1) can then be identified as those outside S1 but inside a circular window centred on the selected origin with a radius such that the window just includes those samples which lie just outside S1.

(4) The samples to be included in the second ordinal value filter (order 2) can be identified by incrementing the radius of the circular window until the next subset of samples lying outside S1 are also encompassed by the window.

(5) The radius of the window is successively incremented to define third and subsequent windows, until a window is defined which encompasses all the samples lying between S1 and S2, (which comprises the final ordinal value filter, order M).

If S1 is vanishingly small, the sample values between S1 and S2 for the first order filter, will simply compose the sample located at the origin, and since an ordinal value filter leaves such a sample unchanged, the first order filter can, in practice, be omitted from the series.

(In the case of a two dimensional lattice of samples, the first mask may, for example, be generally circular. In the case of a single dimensional array, this mask will be linear and be orientated so as to encompass a linear group of the samples. The mask shape does not have to be symmetrical.)

The data-sieve may be used as follows to filter a signal:-

(a) A signal is first filtered using an ordinal value filter (commonly a median filter) of order 1.

(b) Subsequently the output from the order 1 filter is filtered using an ordinal value filter of order 2, and thereafter each filter output is filtered successively with filters of increasing order to a final filtering step where the filter is of order M.

Typically the data samples are arranged in either a one or a two dimensional regular array. The characteristics of a filter such as described above will not normally change in the course of scanning the full sample set.

The method may be realised by providing a cascade of different ordinal value filters connected in series from ordinal value 1 to ordinal value M, with the output of each filter supplying the input to the next in the line, each filter in the line having a higher order than the previous one.

Alternatively the method may comprise the steps of adjusting the order value of a single ordinal value filter through the range 1 to M, instead of using a plurality of different filters, and storing the output signal from each filtering operation whilst the filter value is changed to the next value, before it is supplied to the input of the changed filter. By storing each subsequently filtered signal and incrementally increasing the filter order from 1 to M, the final stored signal will comprise the desired filtered signal for output purposes.

Whilst the series connection of M different filters to form a data-sieve allows a stored array of samples, in one or more dimensions, to be scanned, an alternative method is to have a plurality of data-sieves arranged in an array that simultaneously filter a corresponding plurality of input signals.

The invention is applicable to low pass filtering (as so far described) but may also be applied to high pass filtering and band pass filtering.

If a high pass filter is required, the output from the highest order filter must be subtracted from the raw data. The resulting signal will then only include all signals not eliminated by the data-sieve.

If a band pass filter is required, the output from one of the ordinal value filters in the chain must be subtracted from the output of an earlier one.

The invention also lies in an ordinal value filter in which the order value is adjustable, together with a means for incrementing the order by 1 after each successive application of data thereto, with storage means associated with the input (and/or output) of the filter, for storing the filtered signals and supplying the stored signal to the input of the filter for a subsequent pass through the filter.

Preferably means for counting is provided to determine when a desired order value has been achieved, to terminate the process and release the stored information as an output signal.

The invention also lies in apparatus comprising a plurality of ordinal value filters connected in series with the output of the first connected to the input of the second and so on with each successive filter having an increasing order from a low value associated with the first filter, to a high value associated with the last in the series. Typically the order value increments by 1 from one filter to the next in the series.

The invention may be applied to any information bearing signal whether derived from an optical to electrical converter such as a camera (TV or solid state), or from a transducer detecting sound or vibration or other varying physical, chemical, electro-chemical, atomic or particle activity.

The invention may be employed as a decoder to reliably separate pulses of one width from pulses of other widths and may for example be used in conjunction with pattern recognition apparatus to clean up information to be processed for pattern matching purposes. In this way the invention can be thought of as separating objects of one size from objects of another size.

The invention will now be described by way of example with reference to the accompanying drawings in which:-

Figure 1 illustrates diagrammatically one embodiment of the invention, for simplicity a single dimension filter, and

Figure 2 is a table which illustrates the advantage of using the series of ordinal value filters of the invention, relative to single and repeat median filtering of data samples from one dimensional data.

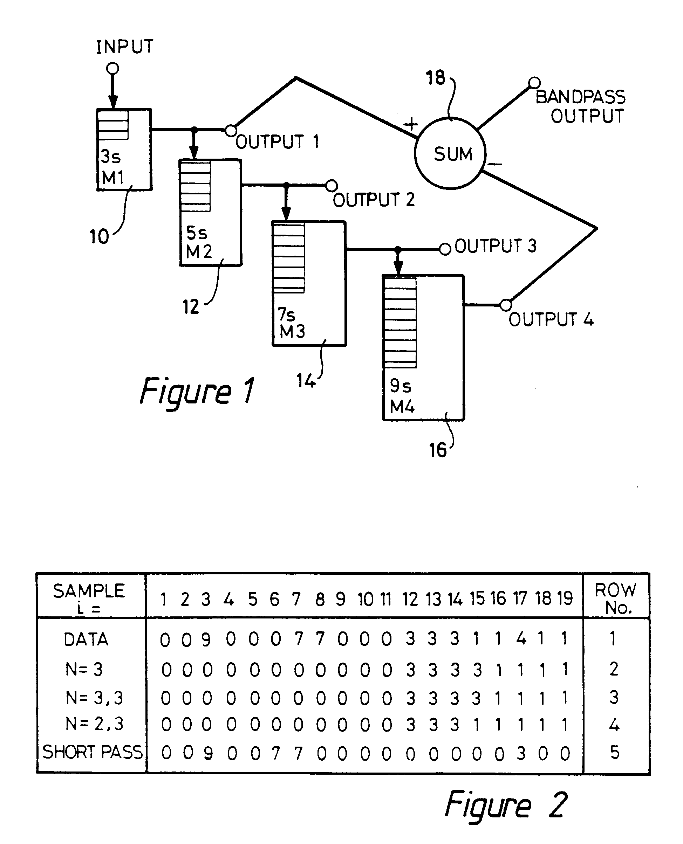

In accordance with the invention the embodiment shown in Figure 1 comprises a cascade of conventional median filters each with a wider window (i.e. a higher order) than the previous one, connected together in series. The resulting (low pass) output is taken from the output of the final filter.

A filter that processes samples, representing a signal in one dimension, with a mask window S1 encompassing no samples, and a final mask window S2 encompassing 9 samples, with a central origin, is shown in Figure 1. The input signal is first filtered through an ordinal value filter 10 (in this case taking the median) of order 2, which encompasses 3 samples. The output is passed to a second conventional ordinal value filter 12, of order 3, and the output of this is passed to a third ordinal value filter 14, of order 4, whose output is passed to the fourth and last filter 16, of order 5.

The filters are sometimes described in relation to the minimum pulse width R (i.e. pulse duration) which will be passed by the filter, and in this context, the first filter (of order 2) can be thought of as having a window width of three samples (i.e. $R = 3$) Since it will remove pulses represented by less than two samples.

The second filter (of order 3) has a window of width of five (i.e. $R = 5$) samples and therefore removes pulses represented by less than 3 samples etc.

The window widths R are not constrained to odd numbers of samples, although the nature of median filters and of single dimensional data streams makes it normally convenient to design median filters for use with single dimensional data streams in this way.

A band pass filter can be produced by subtracting a later output from an earlier one, such as shown in Figure 1, in which a sampling amplifier constructed as a subtraction stage, is connected between Output 1 and Output 4.

A high pass filter (sometimes referred to as a short pass filter) can be produced by subtracting the final output from the original input signal.

The table of Figure 2 illustrates how the present invention is an improvement over a single or multiple pass median filter and also illustrates the high pass filter characteristic in the bottom line of the table.

The top line of the table indicates nineteen sampling intervals along an electrical signal.

Row 1 of the table illustrates numerical values which might be found at the different sampling points in a typical data signal. Thus at position 3 a spurious noise spike of one sampling pulse interval duration and having an amplitude of nine units is found. A similar noise spike of two sampling intervals duration (but having a smaller amplitude of seven units) is found at positions 7 and 8. A true information amplitude excursion is found at positions 12, 13 and 14 having an amplitude of three units and thereafter a typical drifting base line situation is illustrated with a spurious noise spike of three units superimposed over the base line in that positions 15 to 19 have values of 1, 1, 4, 1 and 1 respectively.

If we consider this signal applied to a single median filter of window width 5 the output from the filter will be as shown in Row 2. Such a filter has a total window width of five sampling points (2N - 1) and from a study of Row 2 it will be seen that the whole of the true information amplitude excursion will be transmitted by the filter, an additional extra sampling interval will be added at position 15 to extend the trailing edge of the true amplitude excursion and filter will produce for the remaining sampling positions 16, to 19 a value of 1.

This demonstrates how a simple median filter having a value of N = 3 will be confused if a second significant excursion (whether a true one or otherwise) follows the trailing edge of a previous true excursion by a distance (i.e. number of sampling intervals) less than the N value of the filter concerned. In the example shown the N value is 3 and the sampling point spacing between the trailing edge of the true excursion at 14 and the leading edge of a noise spike at 17 is only two sampling intervals. As a consequence the trailing edge of the true pulse is extended by one sampling interval.

Row 3 of the table illustrates the effect of repeating the median filtering using the same median filter (or another median filter having the same N value) and it will be noted that the corrupted value of the true information excursion in the original signal still appears in the output of the median filter. In fact were the signal to be passed through the median filter an infinite number of times, the width of the pulse beginning at position 12 would remain unaltered and the same incorrect pulse would appear at the output of the filter every time.

If now a filter constructed in accordance with the invention is used the result will be as shown at Row 4 of the table. Here the first stage of the filter has an N value of 2 and the second an N value of 3, so that the overall result will he exactly the same i.e. all pulses having a duration of less that 3 sampling intervals will be eliminated. Note however that in this case the length of the true information excursion in the original data is not corrupted by the addition of a false value at point 15 and the output from the second stage of the two stage filter is a true representation (within the limits of the sampling accuracy) of the original data.

Note also that in both cases the last positions of the output signal also register level 1, since the change in base line value of the signal has extended over a period of more than three sampling intervals. However the spurious pulse sitting at position 17 is not seen and the value at this point is reduced to the pedestal value of 1, corresponding to the base line value at positions 15, 16, 18 and 19.

Row 5 illustrates how the invention can be turned into a short pulse filter (i.e. all pulses of three sampling intervals or greater duration will be discarded and only pulses having shorter durations i.e. one or two sampling pulse intervals will be passed). This is achieved by subtracting the output corresponding to Row 4 of the table from the original data. In this way the noise spikes at position 3, positions 7 and 8 and at position 17 will appear in the output of the subtraction stage but the information excursion excursion bridging at positions 12, 13 and 14, and more importantly still the pedestal appearing at points 15 to 19 will be removed.

It is of interest to note that the noise spike at position 17 is also shown at its correct amplitude of three units relative to the drifting base line, rather than the four units (relative to zero) as shown in Row 1.

This simple example has been given to show how a cascade of steadily increasing window width median filters will give greater accuracy than when a single median filter is used whether or not the filtering step using the single filter is repeated.

In an alternative arrangement (not shown) the four median filters shown in Figure 1 may be replaced by a single median filter (having adjustable N = value) provided the input information can be stored in a convenient memory (such as a "first in first out" (F.I.F.O.) memory device) after each passage through the filter, to enable it to be recycled through the filter a number of times with the N value of the filter being increased with each successive pass. The final resulting signal which passes into the memory after the last pass through the filter will correspond to the desired filtered version of the input signal and can be provided as the output signal by appropriately redirecting the output of the memory device away from the input of the median filter, to an output of the filter. This may be achieved automatically by a counter, which simply counts the number of cycles and gates the output of the memory device when the required number of cycles has been completed.

Where the original data must be retained two "first in first out" (F.I.F.O.) memories may be provided, one to store the original data, and the other to act as a buffer and store the filtered version of the original data, and then the subsequent filtered versions of the contents of the buffer as it is recycled through the median filter. In this arrangement the output from the first memory may need to be recycled as it is read into the input of the median filter on the first occasion, so as to act as a refresh for the memory and thereby preserve the original data.

The output from the second F.I.F.O. memory associated with the output of the median filter is applied to the input of the median filter after the original data has been secured in the first F.I.F.O. memory, to filter the first signal this time with a higher N value. Recycling is continued with step-wise increase of N value as previously described and at the end of an appropriate number of cycles, the signals stored in the second F.I.F.O.memory will correspond to the final filtered signal whilst the original data remains in the first memory.

If a high pass filter is required (i.e. the elimination of pulses of duration greater than a particular number of sampling intervals) then the two memories can be read out simultaneously to a suitable arithmetic stage adapted to subtract one from the other.

If a band pass filter effect is required then the information in the first memory must be replaced with the output from the appropriate one of the median filter steps during the sequence of filtering steps and the output from the first and second memories again subtracted at the end of the process.

If the first memory must preserve the original data for other purposes, a third memory will be required for storing the output from the intermediate median filtering step.

One embodiment of the invention thus comprises a multiple stage filter comprising N - 1 original value filtering stages connected in series, each stage being a conventional median filter and the filter width of each stage is incremented by two starting with the first filter of width three. The output of the cascade filter behaves as a low pass data-sieve removing signals and noise that occupy widths of less than N sample intervals in the data stream. As described high pass and band pass filters can be constructed by subtracting the output of later stages from either the input or an intermediate stage.

Although the methods and apparatus described herein have tended to imply the presence of electrical signals, it is to be understood that the invention is not limited to systems which employ/generate electrical signals but is equally applicable to any system, such as an optical system where the information is in the form of modulated light beams.

## Claims

1. A method of ordinal value filtering a signal conglomerate to remove unwanted signals from wanted signals, comprising the steps of:-
   (i) ordinal value filtering at least a selected part of the signal conglomerate with a filter value N = n,
   (ii) subsequently ordinal value filtering the output the first filter with a filter value (n + x) and thereafter filtering the successive filter outputs with increasing filter values up to (N + M), and

   (iii) utilising the output of the final ordinal value filtering step where x = M as at least part of the final output signal.

2. A method according to claim 1, for removing unwanted items of data from wanted items of data in a conglomerate of items, comprising the steps of:-
   (i) selecting a group of the items from the conglomerate,
   (ii) processing the selected items of data by successive ordinal value filtering with increasing order, to provide a first data output,
   (iii) selecting at least one different group of the items from the conglomerate and processing each different group by the same succession of increasing order ordinal value filtering to provide second and subsequent data outputs, and
   (iv) either applying the succession of data outputs as the filtered output or combining the succession of data outputs with other data, to form the filtered output signal.

3. A method according to claim 2 wherein, where the conglomerate of items of data is in one dimension, such as a series of electrical signals whose amplitude varies, and which are spaced by distance and/or times, the selected groups comprise groups of successive ones of the varying amplitude signals, whilst where the conglomerate of items of data is in two dimensions, such as sampled values of an electrical signal arising from the scanning of a succession of lines in a television type scanners, the selected groups comprise successive similar arrays of the sampled values, each group including sample values from two or more lines of the original scanning.

4. A method according to claim 1, applied to ordinal value, for example median, filtering to remove spurious noise spikes ranging in duration, area or volume, from one signal sample up to a maximum of (M-1) samples, in which the filter comprises a series of ordinal value filters, typically median filters, of increasing order, and the number of samples included in the groups applied to the succession of filters together with the geometrical arrangement of the samples in each group is selected to produce the required properties fro the overall filter.

5. A method according to any of claims 1 to 4 , utilising a data-sieve in which two masks are used to characterise any particular filter, wherein:-

(i) a first mask S2 is used to identify all samples or items to be included in the final filter of the series of filters;

(ii) the position of one of the samples encompassed by the first mask S2 is chosen as the origin of the first mask, and a second mask S1, smaller than S2 is centred on the origin of S2 so as to encompass a subset of the samples within by S2;

(iii) the samples to be included in a first ordinal value filter of order 1 are identified as those outside S1 but inside a circular window centred on the selected origin with a radius such that the window just includes those samples which lie immediately outside S1;

(iv) the samples included in the second ordinal value filter order 2 are identified by incrementing the radius of the circular window until the next subset of samples lying outside S1 are also encompassed by the window; and

(v) the radius of the window is successively incremented to define third and subsequent windows, until a window is defined which encompasses all the samples lying between S1 and S2, which comprises the final ordinal value filter of order M.

6. A method according to any of claims 1 to 5, including the step of providing a cascade of different ordinal value filters connected in series from ordinal value 1 to ordinal value M, with the output of each filter supplying the input to the next in the line, each filter in the line having a higher order than the previous one.

7. A method according to any of claims 1 to 5, which includes the steps of adjusting the order value of a single ordinal value filter through the range 1 to M, and storing the output signal from each filtering operation whilst the filter value is changed to the next value before the stored signal is supplied to the input of the changed filter.

8. A method according to claim 5, utilising a plurality of data-sieves arranged in an array simultaneously to filter a corresponding plurality of input signals.

9. A method according to any of claims 1 to 8, wherein, for high pass filtering the output from the highest order filter is subtracted from the raw input signal, whilst for band pass filtering the output from one of the ordinal value filters in the chain is subtracted from the output of an earlier one.

10. A method according to claim 1, applied to filtering to remove spurious noise spikes ranging in duration from one signal sampling interval up to a maximum duration of M sampling intervals, comprising the steps of:-

(i) median filtering the noisy signal with a filter value N = n,

(ii) subsequently median filtering the output from the median filter with a filter value (n + 1) and thereafter successively with filters of values increasing by one at each step, and

(iii) supplying the output of the final median filtering step where N = M as the output signal.

11. An ordinal value filter for carrying out the method of claim 1, in which the order value is adjustable, and means are provided for incrementing the order by 1 after each successive application of data thereto, together with storage means associated with the input and/or output of the filter for storing the filtered signals and supplying the stored signal to the input of the filter for a subsequent pass through the filter, and preferably means for counting to determine when a desired order value has been achieved, thence to terminate the process and release the stored information as an output signal.

12. Apparatus for carrying out the method of claim 1, comprising a plurality of ordinal value filters connected in series with the output of the first connected to the input of the second and so on with each successive filter having an increasing order from a low value associated with the first filter, to a high value associated with the last in the series, typically with the order value incrementing by 1 from one filter to the next in the series.

**Patentansprüche**

1. Ein Verfahren zum Ordinalwertfiltern eines Signalkonglomerats zum Enfernen unerwünschter Signale aus erwünschten Signalen mit den folgenden Stufen:

(i) Ordinalwertfiltern mindestens eines ausgewählten Teiles des Signalkonglomerats mit einem Filterwert N = n,

(ii) anschließend Ordinalwertfiltern der Ausgabe des ersten Filters mit einem Filterwert (n + x) und danach Filtern der darauffolgenden Filterausgaben mit ansteigenden Filterwerten bis zu (N + M) und

(iii) Verwenden der Ausgabe der endgültigen Ordinalwertfilterstufe, wobei x = M mindestens ein Teil des endgültigen Ausgabesignals ist.

2. Ein Verfahren nach Anspruch 1 zum Entfernen unerwünschter Datenteile aus gewünschten Datenteilen in einem Konglomerat von Teilen mit den folgenden Stufen:

(i) Auswählen einer Gruppe von Teilen aus dem Konglomerat,

(ii) Verarbeiten der ausgewählten Datenteile durch aufeinanderfolgendes Ordinalwertfiltern mit ansteigender Ordnung zum Erzielen einer ersten Datenausgabe,

(iii) Auswählen mindestens einer unterschiedlichen Gruppe von Teilen aus dem Konglomerat und Verarbeiten jeder unterschiedlichen Gruppe mit der gleichen Aufeinanderfolge von Ordinalwertfiltern mit ansteigender Ordnung zum Erzielen von zweiten und weiteren sich anschließenden Datenausgaben und

(iv) entweder Anlegen der Aufeinanderfolge der Datenausgaben als die gefilterte Ausgabe oder Zusammenfügen der Aufeinanderfolge der Datenausgaben mit anderen Daten zum Ausbilden des gefilterten Ausgabesignals.

3. Ein Verfahren nach Anspruch 2, wobei, wenn sich das Konglomerat der Datenteile in einer Dimension befindet, wie bei einer Reihe von elektrischen Signalen, deren Amplitude sich ändert und die um einen Abstand und/oder Zeiten auseinanderliegen, die ausgewählten Gruppen Gruppen aufeinanderfolgender Gruppen der sich ändernden Amplitudensignale sind, während, wenn sich das Konglomerat der Datenteile in zwei Dimensionen befindet, wie zum Beispiel die getasteten Beträge eines elektrischen Signals, das sich aus dem Abtasten einer Zeilenfolge in einem fernsehartigen Abtaster ergibt, die ausgewählten Gruppen aufeinanderfolgende ähnliche Anordnungen der getasteten Beträge sind, wobei jede Gruppe getastete Beträge aus zwei oder mehr Zeilen der ursprünglichen Abtastung enthält.

4. Ein Verfahren nach Anspruch 1, angewendet bei einem Ordinalwert, zum Beispiel Medianfiltern, zum Entfernen von Störgeräuschspitzen, die sich über eine Zeitdauer, eine Fläche oder ein Volumen erstrecken, aus einer Signalabtastung bis zu einem Maximum von (M - 1) Abtastungen, bei dem das Filter eine Serie von Ordinalwertfiltern, im typischen Fall Medianfil-

tern, mit ansteigender Ordnung enthält und die Anzahl der Abtastungen, die in den an die Aufeinanderfolge der Filter angelegten Gruppen zusammen mit der geometrischen Anordnung der Abtastungen in jeder Gruppe enthalten sind, so ausgewählt wird, daß die für das Gesamtfilter erforderlichen Eigenschaften erzeugt werden.

5. Ein Verfahren nach irgendeinem der Ansprüche 1 bis 4 unter Verwendung eines Datensiebes, bei dem zwei Masken zum Charakterisieren irgendeines bestimmten Filters verwandt werden, wobei:

(i) eine erste Maske S2 zum Identifizieren sämtlicher Abtastungen oder Teile verwandt wird, die in dem endgültigen Filter der Filterserie enthalten sein sollen;

(ii) die Lage einer der von der ersten Maske S2 umschlossenen Abtastungen als der Ursprung der ersten Maske gewählt wird und eine zweite Maske S1, die kleiner als S2 ist, auf den Ursprung von S2 zentriert wird, um damit eine Untergruppe der Abtastungen durch S2 zu umschließen;

(iii) die Abtastungen, die in einem ersten Ordinalwertfilter der Ordnung 1 einzuschließen sind, werden als die außerhalb von S1, aber innerhalb eines kreisförmigen Fensters identifiziert, das auf den ausgewählten Ursprung mit einem Radius dergestalt zentriert ist, daß das Fenster gerade solche Abtastungen enthält, die unmittelbar außerhalb S1 liegen;

(iv) die in dem zweiten Ordinalwertfilter der Ordnung 2 enthaltenen Abtastungen werden durch Inkrementieren des Halbmessers des kreisförmigen Fensters identifiziert, bis die außerhalb von S1 liegende nächste Untergruppe von Abtastungen auch vom Fenster umschlossen wird, und

(v) der Halbmesser des Fensters wird zum Ausbilden dritter und sich anschließender weiterer Fenster nacheinander inkrementiert, bis ein Fenster ausgebildet ist, das sämtliche zwischen S1 und S2 liegenden Abtastungen umschließt, welches das endgültige Ordinalwertfilter der Ordnung M ist.

6. Ein Verfahren nach irgendeinem der Ansprüche 1 bis 5, einschließlich der Stufe des Ausbildens einer Kaskade von verschiedenen Ordinalwertfiltern, die in Reihe vom Ordinalwert 1 bis zum Ordinalwert M verbunden sind, wobei der Ausgang jedes Filters den Eingang des nächsten Filters in der Reihe beaufschlagt, wobei jedes Filter in der Reihe eine höhere Ordnung als das vorhergehende Filter aufweist.

7. Ein Verfahren nach irgendeinem der Ansprüche 1 bis 5, das die Stufen des Einstellens des Ordnungswertes eines einzigen Ordinalwertfilters im Bereich von 1 bis M und das speichern des Ausgangssignals von jedem Filtervorgang enthält, während der Filterwert vor dem Zuführen des gespeicherten Signals an den Eingang des geänderten Filters auf den nächsten Wert geändert wird.

8. Ein Verfahren nach Anspruch 5 mit Verwendung einer Vielzahl von Datensieben, die in einer Anordnung zum gleichzeitigen Filtern einer entsprechenden Vielzahl von Eingangssignalen angeordnet sind.

9. Ein Verfahren nach irgendeinem der Ansprüche 1 bis 8, wobei zum Kochpaßfiltern die Ausgabe des Filters mit der höchsten Ordnung vom unbearbeiteten Eingangssignal abgezogen wird, während zum Bandpaßfiltern die Ausgabe von einem der Ordinalwertfilter in der Kette von der Ausgabe eines früheren Filters abgezogen wird.

10. Ein Verfahren nach Anspruch 1 in Anwendung auf das Filtern zum Absondern von Störsignalspitzen, die in der Zeitdauer zwischen einem Signalabtastintervall bis zu einer maximalen Dauer von M Abtastintervallen liegen, mit den folgenden Stufen:
    (i) Medianfiltern des Geräuschsignals mit einem Filterwert N = n,
    (ii) anschließend Medianfiltern der Ausgabe vom Medianfilter mit einem Filterwert (n + 1) und anschließend aufeinanderfolgend mit Filtern mit einem pro Stufe um 1 ansteigenden Wert und
    (iii) Zuführen der Ausgabe der endgültigen Medianfilterstufe, bei der N = M ist, als das Ausgangssignal.

11. Ein Ordinalwertfilter zum Ausführen des Verfahrens nach Anspruch 1, wobei der Ordinalwert einstellbar ist und Mittel zum Inkrementieren der Ordnung um 1 nach jeder aufeinanderfolgenden Zufuhr von Daten zum Filter vorgesehen sind, zusammen mit mit dem Eingang und/oder Ausgang des Filters zusammenwirkenden Speichermitteln zum Speichern der gefilterten Signale und Zuführen des gespeicherten Signals zum Eingang des Filters für einen sich anschließenden Durchgang durch das Filter, und vorzugsweise Mittel zum Zählen, um festzustellen, wann ein gewünschter Ordnungswert erreicht worden ist, um dann das Verfahren abzuschließen und die gespeicherte Information als ein Ausgangssignal freizugeben.

12. Gerät zum Durchführen des Verfahrens nach Anspruch 1 mit einer Vielzahl von Ordinalwertfiltern, die mit dem Ausgang des ersten, das mit dem Eingang des zweiten verbunden ist, und so weiter in Reihe liegen, wobei jedes sich anschließende Filter eine ansteigende Ordnung ausgehend von einem mit dem ersten Filter verbundenen niedrigen Wert bis zu einem mit dem letzten in der Reihe verbundenen hohen Wert aufweist, wobei der Ordnungswert im typischen Fall von einem Filter zum nächsten in der Reihe um 1 zunimmt.

**Revendications**

1. Procédé de filtrage de la valeur ordinale, d'un conglomérat de signaux, en vue d'opérer la séparation entre des signaux indésirables et des signaux souhaités, comprenant les étapes de :
    (i) filtrage de la valeur ordinale d'au moins une partie sélectionnée du conglomérat de signaux, avec une valeur de filtrage N = n,
    (ii) filtrage subséquent de la valeur ordinale de la sortie du premier filtre, avec une valeur de filtrage (n + x), puis filtrage des signaux de sortie successifs de filtrage, avec des valeurs de filtrage allant en augmentant jusqu'à (N + M), et
    (iii) utilisation du signal de sortie de l'étape de filtrage finale de la valeur ordinale, dans laquelle x = M, en ce qui concerne au moins une partie du signal de sortie final.

2. Procédé selon la revendication 1, pour la séparation entre des éléments de données non souhaités et des éléments de données souhaités, dans un conglomérat d'éléments, comprenant les étapes de :
    (i) sélection d'un groupe d'élément dans le conglomérat,
    (ii) traitement des éléments de données sélectionnés par filtrage successif de la valeur ordinale, avec un ordre allant en augmentant, afin de produire un premier signal de sortie de données,
    (iii) sélection d'au moins un groupe différent des éléments du conglomérat et traitement de chaque groupe différent par la même succession de filtrage, s'opérant en augmentant l'ordre de la valeur ordinale, pour fournir des seconds et subséquents signaux de sortie de données, et
    (iv) soit application de la succession de signaux de sortie a titre de signal de sortie filtré, soit combinaison de la succession de signaux de sortie de données avec d'autres données, de manière à former le signal de sortie filtré.

3. Procédé selon la revendication 2, dans lequel, lorsque le conglomérat d'éléments de données est monodimensionnel, comme dans le cas d'une série de signaux électriques dont l'amplitude varie et qui sont espacés par une distance et/ou une durée, les groupes sélectionnés comprennent des groupes de signaux d'amplitude variable successifs, tandis que, lorsque le conglomérat d'éléments de données est bidimensionnel, tel que dans le cas de valeurs échantillonnées d'un signal électrique provenant de l'exploration d'une succession de lignes dans un appareil d'exploration du type télévision, les groupes sélectionnés comprennent des réseaux analogues successifs de valeurs échantillonnées, chaque groupe comprenant des valeurs d'échantillon de deux ou plusieurs lignes de l'exploration d'origine.

4. Procédé selon la revendication 1, appliqué à une valeur ordinale, par exemple la médiane, avec un filtrage pour enlever les pics de bruits parasites se manifestant dans les limites de la durée, de la zone ou du volume à partir d'un échantillon de signal jusqu'à un maximum de (M-1) échantillons, dans lequel le filtre comprend une série de filtres de valeur ordinale, typiquement des filtres à valeur médiane, ou d'ordre croissant, le nombre d'échantillon compris dans les groupes appliqués à la succession de filtre, conjointement avec l'agencement géométrique des échantillons dans chaque groupe, étant sélectionné de façon à produire les propriétés requises pour le filtre dans son ensemble.

5. Procédé selon l'une quelconque des revendications 1 à 4, utilisant un filtre à données dans lequel deux masques sont utilisés pour caractériser chaque filtre particulier, dans lequel :
    (i) une premier masque S2 est utilisé pour identifier la totalité des échantillons ou des éléments à inclure dans le filtre final de la série de filtres;
    (ii) la position de l'un des échantillons pris en charge par le premier masque S2 est choisie comme origine du premier masque, un second masque S1 (plus petit que S2) étant centré sur l'origine de S2, de façon à traiter un sous-ensemble des échantillons par S2;
    (iii) les échantillons à inclure dans un premier filtre de valeur ordinale d'ordre 1 sont identifiés comme étant ceux situés hors de S2, mais dans une fenêtre circulaire centrée sur l'origine sélectionnée, avec un rayon tel que la fenêtre comprenne exactement les échantillons situés immédiatement à l'extérieur de S1;
    (iv) les échantillons inclus dans le deuxième filtre de valeur ordinale, d'ordre 2, sont identifiés par incrémentation du rayon de la fenêtre circulaire, jusqu'à ce que le sous-ensemble suivant d'échantillons, situé à l'extérieur de S1, soit également pris en compte par la fenêtre, et
    (v) le rayon de la fenêtre est incrémenté successivement, de façon à définir des troisièmes fenêtres et des fenêtres subséquentes, jusqu'à ce que soit définie une fenêtre qui prenne en compte la totalité des échantillons situés entre S1 et S2, comprenant le filtre final de valeur ordinale d'ordre M.

6. Procédé selon l'une quelconque des revendications 1 à 5, comprenant l'étape de mise en cascade de différents filtres de valeur ordinale, reliés en série, allant de la valeur ordinale 1 à la valeur ordinale M, le signal de sortie de chaque filtre alimentant l'entrée du filtre suivant dans la série chaque filtre situé dans celle-ci ayant un ordre plus élevé que le précédent.

7. Procédé selon l'une quelconque des revendications 1 à 5, comprenant les étapes d'ajustement de la valeur d'ordre d'un filtre unique de valeur ordinale en balayant la plage allant de 1 à M, et mise en mémoire du signal de sortie venant de chaque opération de filtrage, pendant que la valeur de filtage est changée pour passer à la valeur suivante, avant que le signal stocké soit fourni à l'entrée du filtre modifié.

8. Procédé selon la revendication 5, utilisant une pluralité de filtres à données, agencés simultanément en une zone afin de filtrer une pluralité correspondante de signaux d'entrée.

9. Procédé selon l'une quelconque des revendications 1 à 8, dans lequel, pour chaque filtre passe-haut, le signal de sortie venant du filtre d'ordre le plus élevé est soustrait du signal d'entrée de la rangée, tandis que, pour le filtre passe-bas, le signal de sortie venant de l'un des filtres de valeur ordinale, dans la chaîne, est soustrait du signal de sortie venant d'un filtre précédent.

10. Procédé la revendication 1, appliqué au filtrage en vue d'éliminer les pics de bruits parasites situés dans une plage de durée, d'un intervalle d'échantillonnage de signaux jusqu'à une durée maximale de M intervalles d'échantillonnage, comprenant les étapes de :

(i) filtrage médian du signal de bruit avec une valeur de filtre N = n,

(ii) filtrage médian subséquent du signal de sortie venant du filtre médian, avec une valeur de filtrage (n + 1) puis, successivement, avec des filtres dont les valeurs vont en augmentant de un à chaque étape, et

(iii) amenée du signal de sortie de l'étape de filtrage final médian, dans laquelle M = N, comme signal de sortie

11. Filtre de valeur ordinale, pour mettre en oeuvre le procédé de la revendication 1, dans lequel la valeur d'ordre est réglable, des moyens étant prévus pour incrémenter l'ordre de la valeur 1 après chaque application successive de données au filtre, conjointement avec des moyens de stockage associés à l'entrée et à la sortie du filtre, en vue de stocker les signaux filtrés et amener le signal stocké à l'entrée du filtre pour opérer un passage subséquent dans celui-ci, et comportant de préférence des moyens de comptage pour déterminer si une valeur d'ordre souhaitée a été atteinte, de manière à faire cesser le processus et libérer l'information stockée, comme signal de sortie.

12. Appareil pour mettre en oeuvre le procédé de la revendications 1, comprenant une pluralité de filtres de valeur ordinale reliés en série avec la sortie du premier filtre réunie à l'entrée du second filtre et ainsi de suite, chaque filtre dans la succession ayant un ordre allant en augmentant, depuis une valeur inférieure associée au premier filtre, à une valeur supérieur associée au dernier dans la série, typiquement avec la valeur d'ordre incrémentée de la valeur 1 lorsqu'on passe d'un filtre au suivant dans la série.

*Figure 1*

| SAMPLE i = | 1 | 2 | 3 | 4 | 5 | 6 | 7 | 8 | 9 | 10 | 11 | 12 | 13 | 14 | 15 | 16 | 17 | 18 | 19 | ROW No. |
|---|---|---|---|---|---|---|---|---|---|---|---|---|---|---|---|---|---|---|---|---|
| DATA | 0 | 0 | 9 | 0 | 0 | 0 | 7 | 7 | 0 | 0 | 0 | 3 | 3 | 3 | 1 | 1 | 4 | 1 | 1 | 1 |
| N= 3 | 0 | 0 | 0 | 0 | 0 | 0 | 0 | 0 | 0 | 0 | 0 | 3 | 3 | 3 | 3 | 1 | 1 | 1 | 1 | 2 |
| N= 3,3 | 0 | 0 | 0 | 0 | 0 | 0 | 0 | 0 | 0 | 0 | 0 | 3 | 3 | 3 | 3 | 1 | 1 | 1 | 1 | 3 |
| N= 2,3 | 0 | 0 | 0 | 0 | 0 | 0 | 0 | 0 | 0 | 0 | 0 | 3 | 3 | 3 | 1 | 1 | 1 | 1 | 1 | 4 |
| SHORT PASS | 0 | 0 | 9 | 0 | 0 | 7 | 7 | 0 | 0 | 0 | 0 | 0 | 0 | 0 | 0 | 0 | 3 | 0 | 0 | 5 |

*Figure 2*